# EUROPÄISCHE PATENTSCHRIFT

(11) **EP 0 789 396 B1**
(45) Veröffentlichungstag und Bekanntmachung des Hinweises auf die Patenterteilung: **14.06.2006**
(21) Anmeldenummer: 96810883.7
(22) Anmeldetag: 19.12.1996
(51) Int. Cl.: H01L 23/367

(54) **Kühlkörper für Halbleiterbauelemente od. dgl.**
Cooling member for semi-conductor components or the same
Coups de refroidissement pour des composants semi-conducteurs ou autres choses pareilles

(30) Priorität: 31.01.1996 DE 29601584 U
(43) Veröffentlichungstag der Anmeldung: 13.08.1997
(73) Patentinhaber: Alcan Technology & Management AG, 8212 Neuhausen am Rheinfall (CH)
(72) Erfinder: Lazzarini, Luca, 78224 Singen (DE); Lopes dos Santos, Rogenio P., 78247 Weiterdingen (DE)

(56) Entgegenhaltungen:
- EP-A- 0 483 058
- EP-A- 0 623 952
- DE-A- 2 502 472
- DE-U- 9 412 460
- US-A- 5 038 858

## Beschreibung

Die Erfindung betrifft einen Kühlkörper für Halbleiterbauelemente od.dgl. Geräte -- insbesondere eine Hochleistungskühleinheit -- aus stranggepreßtem Aluminium oder anderem Leichtmetall mit in Abstand zueinander an eine Grundplatte angeschlossenen und davon aufragenden Kühlrippen, die jeweils mittels eines Kupplungssockels in einer Einsatznut od.dgl. Ausnehmung der Grundplatte festliegen, wobei neben jeder eine Ventilrippe aufnehmenden Einsatznut in der Grundplatte eine Hilfsnut zur zeitweiligen Aufnahme eines Werkzeuges angeordnet ist.

Die DE-PS 35 18 310 beschreibt eine derartige Kühleinheit mit in die Oberfläche der Grundplatte eingeformten Einsatznuten rechteckigen Querschnitts zur Aufnahme des Kupplungssockels einer Kühlrippe. Die Mittelachse der Einsatznut ist deren -- und des Kupplungssockels -- Symmetrieachse. Der Kupplungssockel ist mit Längsrippen und -- von diesen begrenzten -- längsgerichteten Seitennuten versehen, in welche während des Herstellungsprozesses durch ein verformendes -- querschnittlich keilartiges -- Werkzeug Grundplatten-Matrix eingepreßt wird; so entsteht ein formschlüssiger Verbund zwischen Kühlrippe und Grundplatte. In letzterer werden durch die Verformung sowohl in Längs- als auch in Querrichtung Spannungen erzeugt, die zum festen Sitz der Kühlrippen wesentlich beitragen; die Rückfederung der zwischen Einsatznut und Hilfsnut verbleibenden engen Rippenabschnitte des Grundprofiles wird kompensiert. Dieser Rückfederungseffekt nimmt naturgemäß mit steigender Festigkeit des Grundwerkstoffes zu. Entsprechend hoch müssen dann die erzeugten Spannungen in der Grundplatte -- und damit die Stanzkraft -- sein, was wiederum zu größeren Planheitsabweichungen der Grundplatte führen kann.

Die entsprechend dem Keilwinkel des verformenden Werkzeuges auf die Grundplatte gerichtete Kraftkomponente führt zu einer rückbildenden elastischen Verformung. Ein sicherer Kontakt zwischen der Unterseite des Kupplungssockels einerseits und der Grundplatte anderseits kann kaum erreicht werden, und ein Wärmefluß über Grundplatte und Unterseite des Kupplungssockels findet nur in vernachlässigbarer Größenordnung statt; der Wärmefluß wird lediglich über die Flanken dieses Kupplungssockels geführt.

In Kenntnis dieses Standes der Technik hat sich der Erfinder die Aufgabe gestellt, eine verbesserte Verspannung der Kühlrippe in der Grundplatte bei möglichst geringer stanzkraft zu erreichen sowie damit die Kühlleistung je Volumeneinheit weitergehend zu verbessern.

Zur Lösung dieser Aufgabe führt die Lehre nach dem unabhängigen Anspruch; die Unteransprüche geben günstige Weiterbildungen an.

Erfindungsgemäß ist in die Grundplatte im -- von Seitenwand und Nutengrund bestimmten -- Eckbereich der Einsatznut eine vom Nutengrund in die Grundplatte hinein geneigte Zusatznut eingeformt; deren Neigungswinkel mit der -- bevorzugt eine Symmetrieachse bildenden -- Mittelachse der Einsatznut liegt unter 90°, vorteilhafterweise zwischen 50° und 70°.

Nach einem weiteren Merkmal der Erfindung ist der Querschnitt der Zusatznut gerundet; seine Kontur besteht aus einem Teilkreis und davon ausgehenden, zueinander parallelen Tangenten. Die größte Querschnittslänge entspricht bevorzugt etwa einem Drittel der Einsatznuttiefe.

Dank dieses Paares von Zusatznuten beidseits der Einsatznut wird die erwähnte Rückfederung vermindert. Die erfindungsgemäße Nutform führt zu einer auf den unteren Teil der Grundplatte gerichtete Verformung der Nutflanken oder - seitenwände und so zu einer zusätzlichen Spannungskomponente. Durch den Formschluß zwischen der Unterfläche des Kupplungssockels und der Grundplatte wird ein wesentlich verbesserter Wärmeübergang geschaffen und damit eine deutliche Qualitätsverbesserung des Verbundes zwischen Kühlrippen und Gehäuse bzw. Grundplatte.

Weitere Vorteile, Merkmale und Einzelheiten der Erfindung ergeben sich aus der nachfolgenden Beschreibung eines bevorzugten Ausführungsbeispieles sowie anhand der Zeichnung; diese zeigt in
- Fig. 1:: die Frontansicht einer Hochleistungskühleinheit aus einem Kühlkörper mit Kühlrippen;
- Fig. 2:: einen vergrößerten Ausschnitt aus Fig. 1 mit einer einzelnen Kühlrippe während der Herstellung der Hochleistungskühleinheit;
- Fig. 3:: einen vergrößerten Ausschnitt aus Fig. 2 ohne Kühlrippe;
- Fig. 4:: den -- vergrößerten -- Ausschnitt der Fig. 2 in einer nachfolgenden Herstellungsstufe;

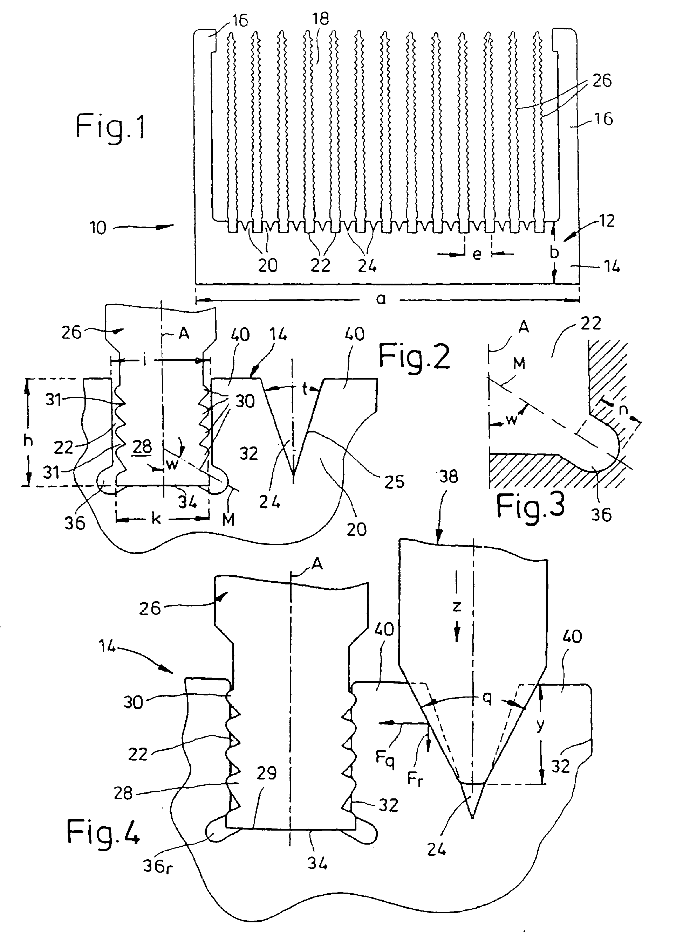

Eine Hochleistungskühleinheit aus Leichtmetall -- insbesondere aus AlMgSi0.5 F 22 -- für in der Zeichnung aus Gründen der Übersichtlichkeit nicht weiter dargestellte Halbleiterbauelemente weist gemäß Fig. 1 einen Kühlkörper 10 mit einem Gehäuse 12 aus einer Grundplatte 14 der Breite a von beispielsweise 150 mm und einer Dicke b von hier 25 mm sowie beidseits an die Grundplatte 14 angeformten Flankenwänden 16 auf. Letztere bilden mit der Grundplatte 14 einestranggepreßte -- Rechteckrinne.

In die Grundplatte 14 sind zum Gehäuseinnenraum 18 hin offene -- durch Bodenrippen 20 voneinander getrennte -- Einsatznuten 22 rechteckigen Querschnitts der Tiefe h von beispielsweise 4 mm angeformt; die Einsatznuten 22 sind zueinander in einem Abstand e ihrer Mittelachsen A von 10 mm sowie wechselweise mit Hilfsnuten 24 etwa V-förmigen Querschnitts angeordnet. Die Hilfsnuten 24 verlaufen in den erwähnten Bodenrippen 20.

In die Einsatznuten 22 rechteckigen Querschnitts der Breite i von 4 mm wird jeweils eine -- parallel zu den Flankenwänden 16 gerichtete -- Kühlrippe 26 mit einem den Nutenquerschnitt i. w. ausfüllenden Kupplungssockel 28 der Breite k eingesetzt; aus dessen beiden Seitenflächen sind jeweils vier Längsleisten 30 etwa sägezahnartigen Querschnitts herausgeformt.

Von den -- durch Seitenwand 32 und Nutengrund 34 gebildeten -- Ecken der Einsatznuten 22 geht jeweils eine querschnittlich gerundete Zusatznut 36 aus. Deren Symmetrie- oder Mittellinie M ist zur Mittelachse A der Einsatznut 22 geneigt und schließt mit letzterer einen Neigungswinkel w von etwa 60° ein. Deren Querschnittslänge n entspricht etwa einem Drittel der Tiefe h der Einsatznut 22.

Zum Festlegen der Kühlrippe 26 in der Grundplatte 14 werden die Seitenwände 32 der Einsatznut 22 verformt. Gemäß Fig. 3 wird in die benachbarte Hilfsnut 24, deren Seitenwände 25 einen Querschnittswinkel t von etwa 35° bestimmen, ein querschnittlich keilartiges Quetschwerkzeug 38 eingesetzt, dessen Keilwinkel q mit mehr als 55° größer ist als jener Querschnittswinkel t der Hilfsnut 24. Das Werkzeug 38 verformt zunächst den oberen Bereich des von Einsatznut 22 und Hilfsnut 24 begrenzten Rippenabschnitts 40 durch eine Querkraft Fq und preßt die Seitenwandmatrix in Form von Werkstoffwülsten in von den Längsleisten 30 begrenzte Längsnuten 31 des Kupplungssockels 28. Mit zunehmender Eindringtiefe y des Werkzeuges 38 in Druckrichtung z baut sich eine Vertikalkraft Fᵥ auf, die unter Verminderung des Querschnitts der Zusatznuten 36 den Kupplungssockel 28 auf den Nutgrund 34 drückt. Hierdurch wird ein zusätzliches Verspannen der Kühlrippe 26 erreicht.

Durch die Sollbiegestelle an der durch die verformten Zusatznuten 36ᵣ erreichten geschwächten Stelle an den Rippenabschnitten 40 der Grundplatte 14 wird die Stanzkraft spürbar reduziert, ohne daß dies zu Lasten des Festsitzes der Kühlrippen 26 ginge.

## Patentansprüche

1. Kühlkörper für Halbleiterbauelemente od.dgl. Geräte, insbesondere Hochleistungskühleinheit, aus stranggepreßtem Aluminium oder anderem Leichtmetall, mit in Abstand zueinander an eine Grundplatte angeschlossenen und davon aufragenden Kühlrippen, die jeweils mittels eines Kupplungssockels in einer Einsatznut od.dgl. Ausnehmung der Grundplatte festliegen, wobei neben jeder eine Kühlrippe aufnehmenden Einsatznut in der Grundplatte eine Hilfsnut zur zeitweiligen Aufnahme eines Werkzeuges angeordnet ist,
**dadurch gekennzeichnet,**
**daß** in dem von Seitenwand (32) und Nutengrund (34) bestimmten Eckbereich der Einsatznut (22) in die Grundplatte (14) eine Zusatznut (36) eingeformt ist.

2. Kühlkörper nach Anspruch 1, **dadurch gekennzeichnet, daß** die Mittellinie (M) der Zusatznut (36) mit der Mittelachse (A) der Einsatznut (22) einen zum Nutengrund (34) gerichteten Neigungswinkel (w) von weniger als 90° einschließt.

3. Kühlkörper nach Anspruch 2, **gekennzeichnet durch** einen von den beiden Mittellinien (M) der Zusatznuten (36) bestimmten Neigungswinkel zwischen 100° und 140°.

4. Kühlkörper nach Anspruch 2, **gekennzeichnet durch** einen Neigungswinkel (w) zwischen Mittelachse (A) und Mittellinie (M) von etwa 60°.

5. Kühlkörper nach einem der Ansprüche 1 bis 4, **dadurch gekennzeichnet, daß** die Zusatznut (36) einen endwärts gerundeten Querschnitt aufweist.

6. Kühlkörper nach Anspruch 5, **gekennzeichnet durch** einen Querschnitt aus einem Teilkreis und zwei zueinander parallelen Tangenten an diesen.

7. Kühlkörper nach einem der Ansprüche 1 bis 6, **gekennzeichnet durch** ein Verhältnis der Querschnittslänge (n) der Zusatznut (36) zur Tiefe (h) der Einsatznut (22) zwischen 1 : 4 und 1 : 3.

## Claims

1. Heat sink for semiconductor devices or the like, in particular a high-efficiency cooling unit, made from extruded aluminium or another light metal, comprising cooling fins connected at a distance from one another to a base plate and projecting therefrom, each fixed by means of a coupling base in an insertion slot or similar recess in the base plate, an auxiliary slot for temporarily receiving a tool being arranged alongside each insertion slot in the base plate receiving a cooling fin, **characterised in that** an additional slot (36) is moulded into the base plate (14) in the corner region of the insertion slot (22) defined by the side wall (32) and the bottom (34) of the slot.

2. Heat sink according to claim 1, **characterised in that** the centre line (M) of the additional slot (36) includes an angle of inclination (w) directed towards the bottom (34) of the slot with the centre axis (A) of the insertion slot (22) of less than 90°.

3. Heat sink according to claim 2, **characterised by** an angle of inclination defined by the two centre lines (M) of the additional slots (36) of between 100° and 140°.

4. Heat sink according to claim 2, **characterised by** an angle of inclination (w) between the centre axis (A) and the centre line (M) of approximately 60°.

5. Heat sink according to one of claims 1 to 4, **characterised in that** the additional slot (36) has a cross section which is rounded at its end.

6. Heat sink according to claim 5, **characterised by** a cross section consisting of part of a circle and two parallel tangents thereto.

7. Heat sink according to one of claims 1 to 6, **characterised by** a ratio of the cross-sectional length (n) of the additional slot (36) to the depth (h) of the insertion slot (22) of between 1 : 4 and 1 : 3.

## Revendications

1. Corps de refroidissement pour éléments de semiconducteurs ou appareils similaires, en particulier unité de refroidissement à haut rendement, en aluminium extrudé ou en un autre métal léger, avec des ailettes de refroidissement raccordées à distance les unes des autres à une plaque de fond et débordant de celle-ci, qui sont posées chacune fixement dans une rainure d'insertion ou dans un creux de ce genre de la plaque de fond à l'aide d'un socle d'accouplement, une rainure auxiliaire étant disposée à côté de chaque rainure d'insertion recevant une ailette de refroidissement dans la plaque de fond pour recevoir temporairement un outil,
**caractérisé en ce que**
une rainure supplémentaire (36) est moulée dans la zone d'angle de la rainure d'insertion (22) dans la plaque de fond (14) définie par la paroi latérale (32) et le fond de la rainure (34).

2. Corps de refroidissement selon la revendication 1, **caractérisé en ce que** la ligne médiane (M) de la rainure supplémentaire (36) avec la ligne médiane (A) de la rainure d'insertion (22) inclut un angle d'inclinaison (w) orienté vers le fond de la rainure (34) de moins de 90°.

3. Corps de refroidissement selon la revendication 2, **caractérisé par** un angle d'inclinaison compris entre 100° et 140° déterminé par les deux lignes médianes (M) des rainures supplémentaires (36).

4. Corps de refroidissement selon la revendication 2, **caractérisé par** un angle d'inclinaison (w) d'environ 60° entre l'axe médian (A) et la ligne médiane (M).

5. Corps de refroidissement selon l'une quelconque des revendications 1 à 4, **caractérisé en ce que** la rainure supplémentaire (36) présente une section transversale arrondie à son extrémité.

6. Corps de refroidissement selon la revendication 5, **caractérisé par** une section transversale constituée par un cercle primitif et deux tangentes parallèles l'une à l'autre.

7. Corps de refroidissement selon l'une quelconque des revendications 1 à 6, **caractérisé par** un rapport de la longueur de section transversale (n) de la rainure supplémentaire (36) à la profondeur (h) de la rainure d'insertion (22) compris entre 1 : 4 et 1 : 3.
